Europäisches Patentamt

European Patent Office

Office européen des brevets

(19)

(11) **EP 0 421 526 B1**

## (12) EUROPEAN PATENT SPECIFICATION

(45) Date of publication and mention
of the grant of the patent:
**31.07.1996 Bulletin 1996/31**

(51) Int Cl.$^6$: **H03H 21/00**, H04N 5/21

(21) Application number: **90202581.6**

(22) Date of filing: **01.10.1990**

(54) **Adaptive ghost cancellation circuit**

Adaptive Schaltung zur Geisterbildauslöschung

Circuit adaptatif pour la suppression d'image fantôme

(84) Designated Contracting States:
**DE FR GB**

(30) Priority: **06.10.1989 US 418432**
**06.10.1989 US 418417**
**06.10.1989 US 418430**

(43) Date of publication of application:
**10.04.1991 Bulletin 1991/15**

(73) Proprietor: **Philips Electronics N.V.**
**5621 BA Eindhoven (NL)**

(72) Inventors:
• **Lish, Charles**
**NL-5656 AA Eindhoven (NL)**
• **Herman, Stephan**
**NL-5656 AA Eindhoven (NL)**

(74) Representative:
**Kooiman, Josephus Johannes Antonius et al**
**INTERNATIONAAL OCTROOIBUREAU B.V.,**
**Prof. Holstlaan 6**
**NL-5656 AA Eindhoven (NL)**

(56) References cited:
**EP-A- 0 098 748** **US-A- 4 727 424**

• **IEEE TRANSACTIONS ON BROADCAST AND TV
RECEIVERS.vol. 35, no. 3, August 1989, NEW
YORK US pages 184 - 194; MELIH PAZARCI: 'AN
ADAPTIVE GHOST PROCESSOR FOR
BROADCAST TELEVISION'**
• **ELECTRONICS AND COMMUNICATIONS IN
JAPAN. vol. 68, no. 4, April 1985, NEW YORK US
pages 103 - 112; MASAHARU OBARA: 'AN
AUTOMATIC TRANSVERSAL-TYPE GHOST
CANCELLER'**
• **1990 IEEE INT. SYMPSIUM ON CIRCUITS AND
SYSTEMS NEW ORLEANS (US) , 1-3/5/1990;
P3170-3174; A. LISH " A METHOD OF TAP
CLUSTERING IN AN ADAPTIVE FILTER FOR
VIDEO GHOST CANCELLATION"**

**Description**

In video transmission, multipath reception caused by signal reflections off buildings or other terrestrial objects cause distinct, sometimes distorted time-shifted replicas or ghosts of the image to appear. Additionally, ghosting can be found in cable systems having poorly terminated connections.

US-A-4,727,424 discloses a sampled data filter used in a television automatic ghost cancellation system which employs a single chain of cascaded delay elements having N output terminals for providing N sampled data signals, where N is an integer greater than 1. The filter further comprises M sample scaling circuits, each having an input terminal coupled to receive one of said N sampled data signals, for multiplying said one sampled data signal by a scale factor, where M is an integer greater than 1 and less than N. A crossbar switch matrix couples selected ones of the N output terminals of the delay element chain to the input terminals of respectively different ones of the M sample scaling circuits to implement the several different delayed sequences of samples that are used by the system to cancel several ghost signals. The rows of switch elements in the crossbar switch matrix are coupled to individual delay elements, and the columns of the matrix are coupled to sample scaling circuitry. The scaled samples are summed to develop a pseudo-ghost signal which is combined with the input signal to cancel the ghost signal components.

It is, *inter alia,* an object of the invention to provide improvements in circuits and systems for ghost cancellation. To this end, a first aspect of the invention provides an adaptive transversal filter circuit as defined in claim 1. A second aspect of the invention provides an adaptive transversal filtering method as defined in claim 6. Advantageous embodiments are defined in the dependent claims.

In examining the impulse response of a ghost channel, we find that it is sparse because most of the response values over time are zero. If an inverse filter of the channel were constructed to cancel the echo function, it too can be made sparse, not requiring a multiplier at every tap in its transversal delay line. According to the invention an adaptive ghost cancellation circuit comprises a transversal filter having a reduced set of multipliers. A predetermined reference signal in the transmitted video signal, and an identical reference signal generated in the ghost cancellation circuit are used to identify optimum active multiplier positions and values during the vertical retrace interval. The optimum filter is then used to cancel any ghosts from the received video signal.

These and other aspects of the invention will be apparent from and elucidated with reference to the embodiments described hereinafter.

In the drawings:

Fig. 1 illustrates a conventional adaptive transversal filter;
Fig. 2 shows the error surface for the filter of Fig. 1;
Fig. 3 illustrates a novel ghost cancellation circuit;
Fig. 4 illustrates the circuit of a novel adaptive sparse transversal filter used in the ghost cancellation circuit of Fig. 3;
Fig. 5 shows an example of the filter of Fig. 4 having two filter taps;
Fig. 6 is a matrix structure described in the specification;
Fig. 7 is a transformed error surface
Figs. 8 and 9 are the results of simulation of the ghost cancellation circuits; and
Fig. 10 illustrates a particular technique of ghost cancellation circuit adaptation.

DETAILED DESCRIPTION OF THE INVENTION

In order to facilitate description of the invention, a simple geometrical relationship based on Wiener filter theory is derived. Algorithms for clustering (i.e. locally grouping free multipliers at needed taps) based on the formulation are presented.

1. Adaptive Filtering:

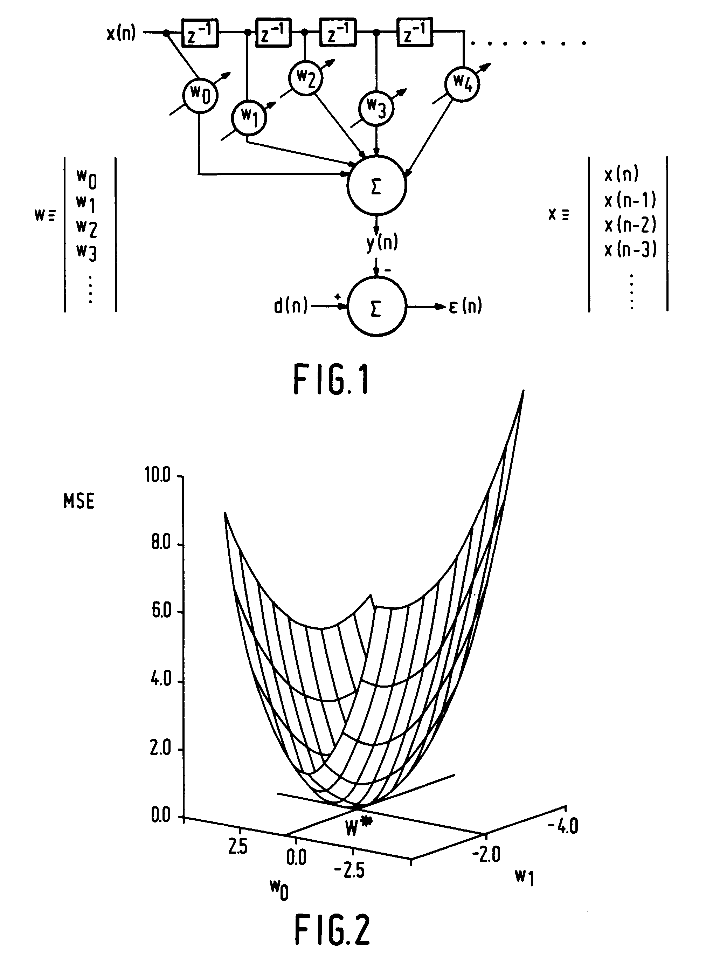

In a finite impulse response (FIR) adaptive filters as shown in Fig. 1 the multiplier values or tap weights and signal are represented by $R^m$ vectors $W^T=\{W_0...W_{m-1}\}$ and $X^T=\{X(n)...X(n-m+1)\}$, respectively. The filter output may then be written as $y(n) = X^TW = W^TX$. To tune the filter output to create a good replication of the reference signal $d(n)$ from input $X(n)$, the error $|\varepsilon(n)|^K = |d(n)-y(n)|^K$ must be minimized. For ease of calculation it is desirable to set K=2 obtaining

$$\varepsilon^2(n) = d^2(n) + W^TXX^TW - 2d(n)X^TW \qquad (1)$$

Expectation operator E is then applied to average out any noise as shown below.

$$e = E[\varepsilon^2(n)] = E[d^2(n)] + W^TE[XX^T]\,W - 2E[d(n)X^T]\,W \qquad (2)$$

where e is the mean square error (MSE).

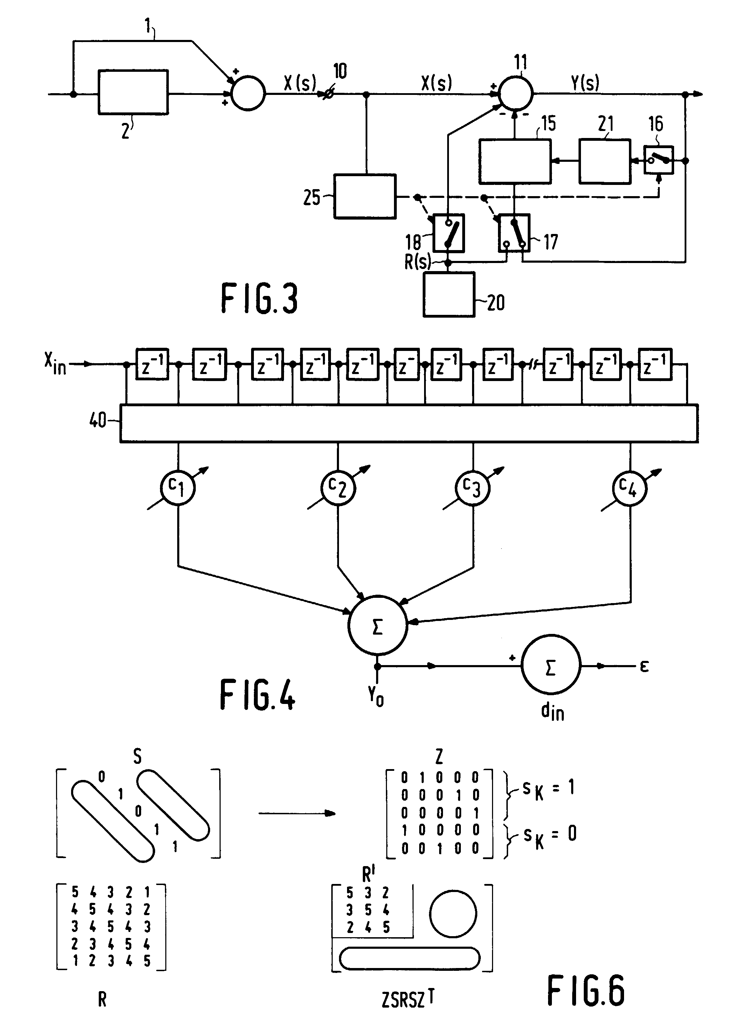

Minimization can then take place by writing the gradient of e with respect to the tap weights obtaining $\nabla$, and then setting this quantity to '0' thus solving for the optimal weight vector W* as shown in Fig. 2 below. W* is known as the Wiener solution with $E[XX^T] = R$ being the input autocorrelation matrix.

$$\nabla = \delta e/\delta W = 2E\,[XX^T]\,W - 2E\,[d(n)X] \tag{3}$$

The condition $\nabla = 0$ yields the optimal solution W* given by eqn. (4).

$$W^* = E[XX^T]^{-1}\,E[d(n)X] \tag{4}$$

Fig. 2 shows an example of a two weight error surface. The quadratic shape of the error surface is determined by R and the center point is W*. Below we describe how this surface is cut when multipliers are deleted from the FIR filter.

From eqn. (4), we can see the difficulty in calculating W*. Long term averaging and complex matrix operations are needed. It is simpler to start with an initial guess of W* and then follow the gradient down the error surface to reach the actual optimum. Because $\nabla$ in eqn. (3) is also difficult to calculate, the least mean square (LMS) gradient estimate may be used. instead of using an actual gradient, the expectation is dropped to obtain

$$\hat{\nabla}(n) = \delta\varepsilon^2(n)/\delta W = 2\varepsilon(n)\,\delta\varepsilon(n)/\delta W \tag{5}$$

The gradient estimate $\nabla(n)$ in final form is obtained after solving for $\delta\varepsilon(n)/\delta W$ from $\varepsilon(n) = d(n) - X^T W$.

$$\delta\varepsilon(n)/\delta W(n) = -\,X(n) \rightarrow \hat{\nabla}(n) = -\,2\varepsilon(n)X(n) \tag{6}$$

If $\nabla(n)$ is time averaged at a particular W on the error surface, $\rightarrow \hat{\nabla}$ (closeness increasing with averaging time, weights are iterated to reach W* by following the gradient as shown below.

$$W(n+1) = W(n) - \mu\,\hat{\nabla}(n)$$

$$= W(n) + 2\mu\varepsilon(n)X(n) \tag{7}$$

Since the constant $\mu$ determines the rate of descent, the time average of $\nabla$ and thus precision is sacrificed when using large $\mu$. There is a compromise between speed and accuracy of adaptation.

A thorough treatment of adaptive filtering can be found in the text: Widrow & Stearns, "Adaptive Signal Processing", Printice-Hall (1985).

## 2. Ghost Cancellation

The image portion of a video signal such as occurs in television broadcasting, is not known to the receiver before reception, thus making it undesirable as a reference signal [d(n)] for adaptive filtering. In the system according to the invention a standardized reference signal is inserted in the vertical interval test signal (VITS) during vertical retrace. A circuit in the receiver generates an identical reference signal simultaneously with the VITS transmitted reference (which is corrupted by an unknown linear ghosting function h(n) before it is received). A signal x(n) = d(n) * h(n) is applied to an adaptive FIR filter input, the top weights may then be adapted to minimize the error e. The FIR filter then approximates inverse ghosting function $h^{-1}(n)$ ; when the picture portion of the signal is passed through the FIR significant ghost reduction takes place. A FIR filter cannot provide complete cancellation, however, because ghosting function h(n) is a finite convolution, and thus has an all zero transfer function. The inverse all pole filter must have infinite impulses response (IIR) for complete cancellation.

The error surface of an IIR adaptive filter is not quadratic and may also have local minima. Additionally, the LMS gradient estimate has recursive terms, making it more complex than the FIR counterpart. Below, we show that it is possible to adapt in FIR mode and retain the complete cancellation provided by an IIR structure; in effect, the best attributes of FIR and IIR filtering can be combined.

Fig. 3 illustrates an adaptive ghost cancellation circuit according to the invention. This circuit operates in a convergence mode or adaptation in which adaptation takes place, and in a ghost cancellation mode. It requires only a single FIR adaptive filter.

The signal transmission path is represented as comprising a direct path 1 as well as an indirect path 2 having a transfer function H(s), the former representing direct reception and the latter reception due only to an echo. The combined signals of these two path components is applied to the ghost canceller circuit at input 10. it should be kept in mind that elements 1, 2 and the indicated summation are not physical elements of the system, but representations of the signal transmission path. The physical invention starts at input 10.

If a reference signal R(s) is transmitted as part of the video signal, its component X(s) of the received signal is given by

$$X(s) = R(s) [1 + H(s)] \qquad (8)$$

and is applied to the subtracter circuit 11. The ghost cancellation circuit is illustrated in the cancellation mode in which the output Y(s) of the subtracter circuit 11 is applied to an adaptive filter 15, and the filter output is fed back to the subtracter circuit 11. Thus, the ghost cancellation circuit output is given by

$$Y(s) = X(s) \{1 + H'(s, T_c)\}^{-1} \qquad (9)$$

If $H'(s,t) = H(s)$ after convergence time T, then

$$Y(s) = R(s) [1 + H(s)] [1 + H'(s, T_c)]^{-1} = R(s) \qquad (10)$$

As can be seen, if $H'(s, T_c) \approx H(s)$, complete ghost cancellation is approached. This adjustment of $H'(s, T_c)$ occurs in the convergence of adaptation mode, where $H'(s, T_c)$ performs system identification of echo channel 2 having transfer function H(s).

In the convergence mode the switches 16, 17 and 18 are set to the positions opposite those shown in the drawing. The reference signal generator 20 develops a reference signal identical to the predetermined reference signal R(s) in the received video signal, and this reference signal is applied through the respective switches 17 and 18 to the adaptive filter 15 and to the subtracter circuit 11. The circuit through switch 18 corresponds to the direct transmission path 1 and the circuit through switch 17 corresponds to the echo signal path. Consequently, the sum of the inputs to the subtracter circuit 11 should be X(s) and -X(s) so that the subtracter circuit output Y(s) effectively be null.

Any non-zero value for Y(s) can be thought of as an error signal representative of the difference between the indirect path transfer function H(s) and the filter transfer function $H'(s, t_c)$. This error signal is applied through switch 16 to the error correction block 21. This block represents a circuit for determining the magnitude of the error signal and for determining the optimum filter tap sites to reduce the error according to some criterion such as the least mean square error. It could be physically realized by a microprocessor based microcomputer for calculating the tap weights according to the equations derived below. The important point is that in the convergence mode the FIR filter 15 is tuned so that its transfer function is made to replicate the indirect signal path 2.

Control circuit 25 is responsive to the received video signal for determining when the vertical retrace interval occurs. Control circuit 25 applies a control signal to the switches 16, 17 and 18 to switch them to the settings for the convergence mode during the vertical retrace interval so that the transmitted reference signal R(s) can be used for adaptation of the filter 15. During the reception of the image part of the video signal the switches 16, 17 and 18 are set for the ghost cancellation mode. Switching between convergence and ghost cancellation modes occurs every time a reference VITS appears, creating the effect of having an IIR adaptive filter continuously available to process the picture.

The indirect or echo channel discrete transfer function, h(n), is sparse because most of the response values over time are zero or insignificant. In the convergence mode, a FIR filter is tuned to replicate the echo transfer function; therefore, many multipliers along the delay taps of the transversal filter are of '0' value, meaning they effectively are unused. Consequently, a FIR filter with a reduced number of moveable multipliers can be employed; multipliers are placed to replicate the clustering properties of the echo transfer function.

Figure 4 shows the adaptive cluster transversal filter. Considering adaptation, our problem is to distribute the multipliers through switching matrix 40 only to the tap locations where they are needed and then adjust them to the correct value. This new filter structure is equivalent to a normal M tap FIR filter having M-N of the multipliers set to zero; his kind of tap weight pattern would be expected when identifying a non-smeared or smeared echo sequence that could be approximated by N active components. Suppose that the N multipliers are distributed in a known pattern that is different from the correct pattern of the active taps required to replicate the echo. We can find out how the optimum associated with this known tap weight pattern is related to that of the global optimum of the filter having multipliers at all M taps. In fact, if we only know the optima of a sufficient number of different patterns containing N multipliers, we can combine this information to reconstruct what would be the global M tap optimum. The zero and non-zero taps can then be identified, leading to the correct multiplier distribution. We call this filter an adaptive sparse transversal filter.

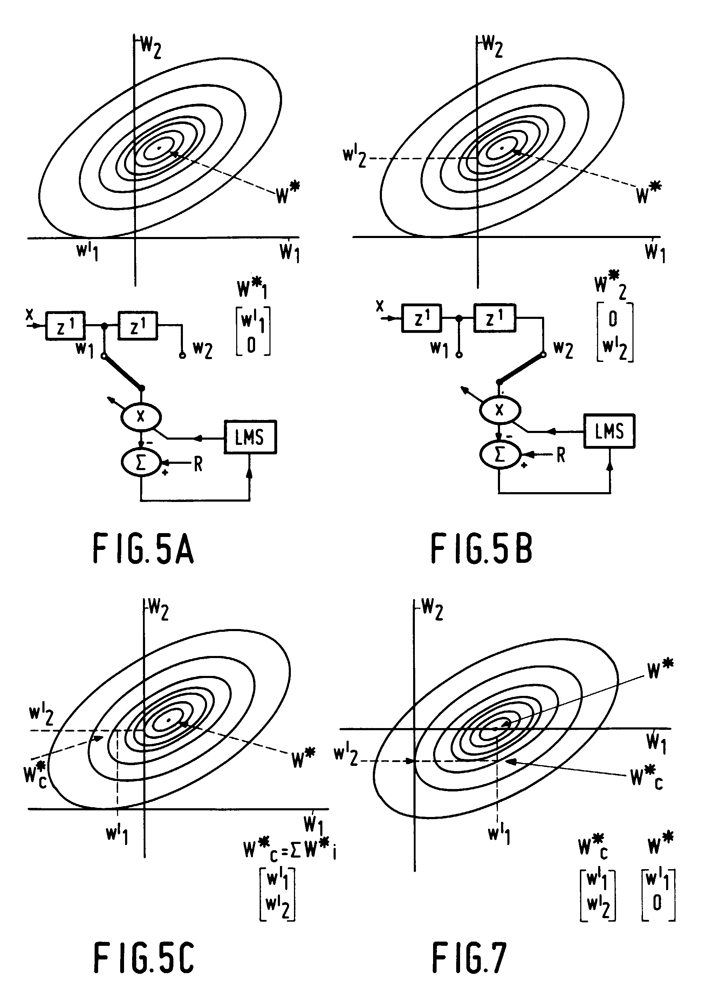

The situation is elaborated in the two tap example of Fig. 5. As shown in Fig. 5A, the single multiplier is first connected to the left delay tap and is optimized using a least mean square (LMS) criterion to setting $W_1'$. When connected to the right delay tap (see Fig. 5B), the optimum is found to be $W_2'$. After combining these coordinates to form $W_c^*$ it is shown in Fig. 5C that this is a point different from global optimum $W^*$. Below, we derive a linear mapping $A_c$ that can relate $W_c^*$ to $W^*$. In the formulation, there are N multipliers to be distributed among M taps of the transversal filter.

To start, Eqs. (3) and (4) are combined so that the gradient is written with respect to $W^*$, where $R = E[XX^T]$, as follows.

$$\nabla = 2RW\text{-}2RW^* \qquad (11)$$

Since the search for minima is being constrained to certain components of W being held to '0', we define switching matrix $S = \text{diag}\{s_K\}$, $s_K = 1,0$. $s_K = 1$ corresponds to taps connected to a multiplier, where $s_K = 0$ corresponds to unconnected taps, and the following holds

$$\Sigma\, S_K = N \text{ over } K = 1 \text{ to } M$$

Multiplying W by S thus nulls the appropriate elements. We additionally wish to pre-null corresponding elements of vector $\nabla$ so as to ignore those components in the optimization procedure. Since some of the elements of W are constrained, the remaining free elements can assume a different optimal solution than the original solution obtained in (3) and (4). To distinguish this new solution, the constrained weight vector will be called $W_s$. The constrained optimum, $W_s^*$, is obtained by setting $S \nabla = 0$, as displayed below. Setting $S \nabla = 0$ and solving for $W_s$ yields the constrained optima, as shown below.

$$S \nabla = S[2RSW_s - 2RW^*]$$

$$[SRS]W^*_s = [SR]W^* \qquad (12)$$

Eq. (12) is written in $R^N$ space, where (11) is in $R^M$; $N < M$. The sub-space operations of (12) are necessary as a pre-requisite for finding the relationship of $W_c^*$ and W in $R^M$. MXM matrix [SRS] is singular since its rank $\leq N$, since not all $S_K = 1$. Consequently, we cannot invert [SRS] directly. We instead need to work with a sub-matrix derived from [SRS] that performs mappings on the non-nulled sub-space of W-space. This NXN sub-matrix can be constructed by permutating all the null columns of [SRS] to the right and null rows to the bottom, leaving the sub-matrix nested in the upper left corner of the full MXM matrix. We note that to preserve correspondence, elements of $W_s^*$ are permutated in the same fashion as the column of [SRS], and the rows of [SR] are permutated to match the rows of [SRS]. A matrix Z will be constructed to perform the permutations. Pre-multiplying by Z permutates a matrix's rows while post-multiplying by $Z^T$ permutates the columns. The equation below shows how Z is formed from $S = \text{diag}(sK)$, where $K = 1,...,M$.

$$Z = [z_{i,k}] = \begin{cases} 1 & \text{if } i = s_K \left[\sum_{i=1,K} s_i\right] + [1-s_K]\left[\sum_{i=1,M} s_i + \sum_{i=1,K}(1-s_i)\right] \\ 0 & \text{otherwise} \end{cases} \qquad (13)$$

In (13), Z starts from an all null MXM matrix where '1' elements are added only at the indices indicated. While column index 'j' is scanned as 'K' goes from 1 to M, row index 'i' is incremented by 1 starting from 0 each time $s_K = 1$; when $S_k = 0$, the row index is also incremented by 1 but starts from

$$\Sigma\, S_i = \text{over } j = 1 \text{ to } M.$$

Thus, every row and column has a single '1' in it with the rest of the elements being '0'. An example is shown in Fig. 6 to aid understanding.

The submatrix of $ZSRSZ^T$ can be constructed to be non-singular since it is a function of R and S, both under our control, and not dependent on echo h(n). Z has the following properties:

$$ZZ^T = I \text{ and } Z^T = Z^{-1} \qquad (14)$$

Applying the described permutation to (12), yields

$$[Z\, SRS\, Z^T]\, ZW^*_s = [Z\, SR]W^* \qquad (15)$$

Considering the non-nulled elements of vectors to be active, we have defined the transformation $W^* \to [Z\, SR]W^*$ which is a mapping $R^M \to R^N$. Similarly, the bottom M-N elements of $ZW_s^*$ are nulled by the zero elements in nested matrix $[Z\, SRS\, Z^T]$, making both sides of (15) elements of $R^N$. We therefore write (15) as

$$R'(Z\, W_s^*)' = ([Z\, SR]W^*)'$$

where the apostrophe indicates the bottom nulled elements of the vectors have been truncated, making them N dimensional; additionally, $R'$ is an NXN invertible matrix corresponding to $[Z\, SRS\, Z_T]$. With this, $(ZW_s^*)'$ can be solved, however, it is desirable to find the solution and preserve the identity of the nulled vector elements for later operations. To solve (15) as described, operation $-1\square$ is defined to perform inversion only on the nested sub-matrix within $[Z\, SRS\, Z^T]$ and place this new matrix back in the same position as the original sub-matrix. Therefore,

$$Z W^*_s = [Z\, SRS\, Z^T]^{-1\square} Z\, SR\, W^* \qquad (16)$$

To further simplify we note that $[Z\, SRS\, Z^T]^{-1} = Z\, SQS\, Z^T$ for some matrix Q having corresponding elements to inverse sub-matrix of R', also $S = S^n$. Applying this to (16) and using (14) yields

$$Z W^*_s = [ZSRSZ^T]^{-\square} ZRW^* \qquad (17)$$

Finally using (17) and (14) we obtain

$$W^*_s = Z^{-1} [ZSRSZ^T]^{-1\square} Z^T RW^* \qquad (18)$$

In (18) the nulled elements of $W_s^*$ are not only preserved, but also permutated to match corresponding elements of $W^*$. The active elements of $W_s^*$ relate in order, to the $s_K = 1$ elements in $S = \text{diag}\{s_K\}$. To summarize, (18) takes R, nulls out appropriate rows and columns, permutates remaining rows and columns to form an N x N sub-matrix, inverts the sub-matrix, and de-permutates the inverted submatrix so that elements occupy the original non-nulled locations creating a 'sub-space inverse of R'. This 'subspace inverse of R' is post multiplied by R yielding the $R^M \rightarrow R^N$ mapping $W^* \rightarrow W_s^*$ having preserved nulled elements.

Suppose that $W_{si}^*$ correspond to switching matrices $S_i$, $i = 1,...,T$ with

$$\Sigma\, s_i = I\ i=1\ \text{to}\ T$$

Then there are sub-spaces $E^{Ni} \leq R^M$, with $W_{si}^* \in E^{Ni}$ and $\cap_i E^{Ni} = \varnothing$ and $U_i E^{Ni} = R^M$. Accordingly we can build $W_c$ in $R^M$ from the $E^{Ni}$ sub-spaces as shown; using (18),

$$W^*_c = \sum_{i=1,T} W^*_{si} = \sum_{i=1,T} [Z_i^{-1} [Z_i S_i R S_i Z_i^T]^{-1\square} Z^{T-1}] RW^* \qquad (19a)$$

$$W^*_c = R_c^{-1} RW^* = A_c W^* \qquad (19b)$$

(19a) and (19b) are $R^M \rightarrow R^M$, and $A_c$ is invertible.

It is clear how sub-space optima, $W_i'$, in Figure 5 are constructed. Since (18) shows that only one optimum exists for a given matrix S (or sub-space), the optimum must be found on the contour tangent to the axis constraining the sub-space.

Now that mapping $A_s$ has been found, it is easy to see how a cluster can be formed. Referring to the two tap example of Figure 7, we see that $W_c^*$ is constructed in the same manner as in Figure 5. Both components of $W_c^*$ are non-zero. If we were to use (19) and then find $A_c^{-1}$, the global optimum, $W^*$, can be calculated. Notice that $W^*$ has a single non-zero component, hence, only one multiplier is needed in this simple cancellation filter.

3. Examples

Combing:

A switching pattern that meets the conditions needed to obtain a valid $W_c^*$ usable in (19) is the comb. We will describe a 3 to 1 comb, but this approach is not restricted to a 3 to 1 ratio. Assuming that the transversal filter in Fig. 4 has M taps, let us say that we find (for example) the worst case echo requires that only N multipliers are needed in this structure at any given time. Let M=3N. To form this comb, distribute the N weights evenly over the 3N taps, leaving a gap of 2 taps between multipliers. The comb can be advanced. More specifically:

(i) Distribute N weights evenly over the first of every third 3N taps; LMS converge and store weight values forming $W_{s1}^*$

(ii) Distribute N weights evenly over the second of every third 3N taps; LMS converge and store weight values forming $W_{s2}^*$

(iii) Distribute N weights evenly over the third of every third 3N taps; LMS converge and store weight values forming $W_{s3}^*$

(iv) Combine stored weight values forming $W_c^*$

In the sequence described, the comb advances position only after each $W_{si}$ has converged to its final value. A useful variation would be to advance the comb after each LMS cycle of (7) thus updating $W_c$* every 3 cycles. Intermediate values of $W_c$* provided with this "cyclic comb" may be desirable in giving continuous subjective improvements to the picture as final convergence is reached.

1. Clustering with R = Λ

a) Find $W_c$* either by advancing or cyclic comb.
b) Select N non-zero values of weights; assign the N multipliers to related locations and set to corresponding weight values. (Some components of $W_c$* would only be zero under ideal conditions with perfect convergence. The correct objective could be achieved by selecting the N maximum magnitude weight values.)

2. Clustering with R ≠ Λ

This algorithm uses steps a) and b) from above. However, the following intermediate step must be added between a) and b).
a′) calculate $W$* = $A_c^{-1} W_c$. $W$* is used in step b).
Since $A_c^{-1}$ is a function of R and $\{S_1,..,S_T\}$, it may be precalculated and stored. It is best to find a reference signal and switching pattern (i.e. a different comb ratio) to lead to a very simple $A_c^{-1}$ structure, as this will facilitate multiplication later.

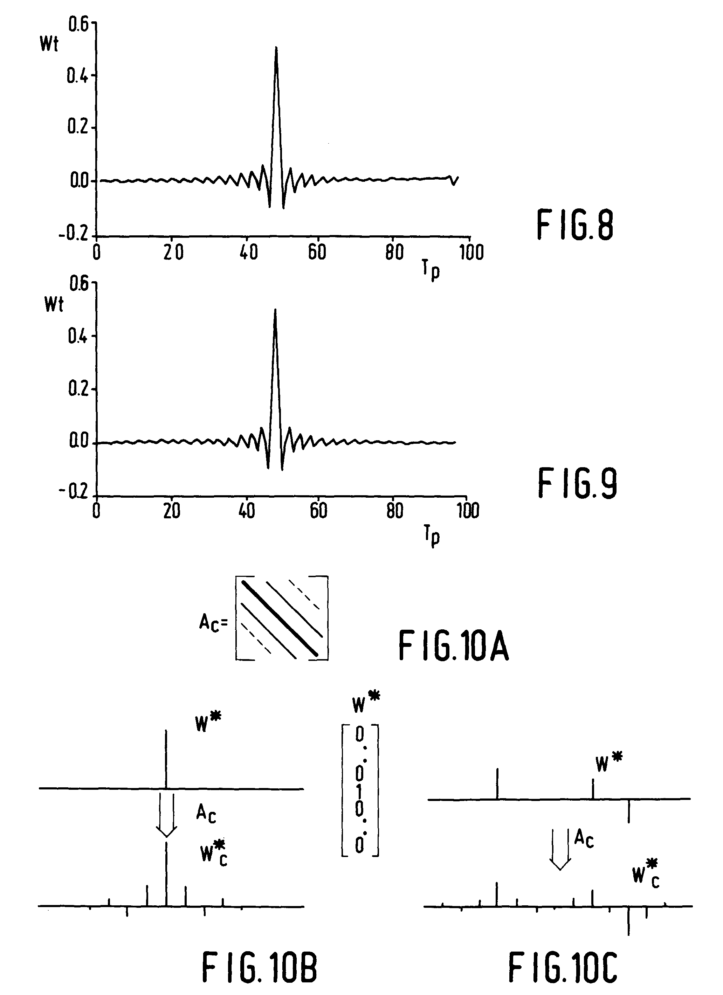

In simulations, a sin x/x reference signal R(s) was chosen for its smooth spectral characteristics (any frequency null would make tuning at that point indeterminate). To match video bandwidth, the sin x/x rolloff was set at 5 MHz. Sampling was done at 3x bandwidth with a 3 to 1 comb switching pattern. $A_c$ was calculated using (19) and found to be practically indistinguishable from $(1/r_{ii})R$. To show the utility of the mapping, a single echo that can be described as having $W$* = {0,0,..,1,..,0,0} was processed with a 3 to 1 Advancing Comb (with LMS as described in this section under 'Combing') to obtain $W_c$*. $W$* was also mapped through $A_c$ to find $W_c$* according to (19b). Figure 8 shows the results of the Advancing Comb while Figure 9 that of the mapping. The horizontal axis shows the tap number Tp while the vertical axis shows weight Wt.

Another embodiment of the invention will be discussed with reference to Figure 10. A single echo is mapped through matrix $A_c$ shown in Fig. 10A, which is effectively Toplitz (i.e., $A_c$ = {$a_{ij}$} = {$a_{i-j}$}), and has a very dominant main diagonal. As in Figure 9, the impulse of $W$* is mapped to an impulse with side-lobes in $W_c$*, see Fig. 10B. The peak position of $W_c$* is the same as the $W$* pulse. Because of the described structure of $A_c$, we can say that any component of $W$* maps to the same spot in $W_c$* with similar side-lobes; superposition can therefore be applied for multiple echoes, see Fig. 10C. In this case the maximum magnitude components of $W_c$* have a high probability of matching the non-zero elements of $W$*. If it is known a priori that the most complex echo will have ≤ N components, then it is highly likely that these will be the N maximum components of $W_c$*. This relationship would not work if the side-lobe of an echo sufficiently lowered the peak amplitude of another echo so as to not be counted in the set of N selected $W_c$* elements; the more dominant the main diagonal of $A_c$, the less likely this event.

3. Course-Fine Clustering Projecting Forward through $A_c$ for a 3x sampled sin x/x; 3 to 1 comb.

a) Find $W_c$* either by advancing or cyclic comb
b) Select N maximum magnitude elements of $W_c$*; assign the N multipliers to related locations and set to corresponding weight values (considered as initial condition)
c) With the weights set as in b), preform final LMS convergence. This fine tunes the weights to match $W$*.

Selection of the maximum magnitude elements in step b) can be by a predetermined threshold, or by setting a threshold value so that the number of elements of $W_c$* having values exceeding the threshold equals N.
In summary, a first aspect of the present invention provides an adaptive ghost cancellation circuit as shown in Fig. 3, which comprises

subtracting means 11 for receiving in operation a video signal which includes a reference signal and for subtracting signals applied thereto from the video signal;
an adaptive finite impulse response filter 15 having an output connected to said subtracting means 11 for the subtraction of a filter output signal from the video signal applied to said subtracting means;
reference signal generating means 20 for generating a reference signal identical to the reference signal contained in the video signal applied to said subtracting means; and
mode switching means 25 for operating the cancellation circuit in a convergence mode and in a ghost cancelling mode, said mode switching means 25 applying the reference signal from said reference signal generator 20 to the input of said adaptive filter 15 and to said subtracting means 11, and applying the output of said subtracting means to said adaptive filter 15 for adjusting the adaptive filter characteristics to converge toward the characteristics of the ghost signal path, and said mode switching means 25 ending the application of the reference signal and applying the output of said subtracting means to the input of said adaptive filter after convergence to cancel ghost signals from the video signal.

Another aspect of the present invention provides a method of optimizing a sparse transversal filter as shown in Fig. 4 which has M taps and N multipliers where N < M, said method comprising:

distributing the N multipliers among the M taps;
optimizing the multiplier values;
storing the optimized multiplier values;
repeating the steps of distributing, optimizing and storing until all of the taps have been utilized; and
combining the optimized multiplier values to form the globally optimum N multiplier values.

If M = 1 < N and k is an integer, the step of distributing the N multipliers may be first carried out evenly over the first and every kN taps; and successive steps of distributing the N multipliers may be carried out by advancing the position of each of the multipliers by one tap.

The method may further comprise the step of adjusting the globally optimum multiplier values to minimize the error between the filter output signal and a reference signal.

## Claims

1. An adaptive filter arrangement (15; 11, 16-25) for filtering a video signal (X(s)) to furnish a filtered video signal (Y(s)), the arrangement comprising:

   an adaptive transversal filter circuit (15) including:

   a plurality of delay elements ($z^{-1}$) connected in series;
   a plurality of multipliers ($c_1$-$c_4$) each connectable to a respective output of a different one of said plurality of delay elements ($z^{-1}$), wherein the number of multipliers ($c_1$-$c_4$) is less than the number of delay elements ($z^{-1}$);
   means (40) for connecting selected ones of the multipliers ($c_1$-$c_4$) to the outputs of respective ones of the delay elements ($z^{-1}$); and
   summing means ($\Sigma$) for summing the output signals of said multipliers ($c_1$-$c_4$) to develop an output signal; the adaptive filter arrangement further comprising:

   control means (11, 16-25) coupled to a control input of said multipliers ($c_1$-$c_4$) and said connecting means (40), <u>characterized in that</u> said control means include:

   subtracting means (11) having an input for receiving said video signal (X(s)) incorporating a vertical interval test signal which includes a predetermined reference signal;
   a reference signal generator (20) for generating a reference signal (R(s)) identical to the predetermined reference signal;
   means (25; 16-18) responsive to the vertical interval test signal for applying (17) the reference signal (R(s)) from said reference signal generator (20) to said adaptive transversal filter (15) to furnish a filtered reference signal to said subtracting means (11), for applying (18) the reference signal (R(s)) to said subtracting means (11) during the occurrence of the reference signal in the received video signal, and for applying (16) an output of said subtracting means (11) to said control input; and
   means (25; 17) for applying in a cancellation mode, the output (Y(s)) of said subtracting means (11) to said adaptive transversal filter (15) to furnish a filtered subtracting means output signal to said subtracting means (11), thereby cancelling ghost signals from the video signal (X(s)) to furnish said filtered video signal (Y(s)).

2. An adaptive transversal filter circuit as claimed in claim 1, wherein said control means include:

   means for comparing the result of the subtraction with a threshold value;

means for connecting said filter multipliers ($c_1$-$c_4$) to said filter delay taps on correspondence to the results of the subtraction which exceed the threshold value; and

means for adjusting the multiplier values ($c_1$-$c_4$) to minimize the result of the subtraction.

3. An adaptive transversal filter circuit as claimed in claim 2, wherein said comparing means are coupled to receive a threshold value set so that all multipliers ($c_1$-$c_4$) are used.

4. An adaptive transversal filter circuit as claimed in claim 1, wherein said control means are arranged to control the connections of said multipliers ($c_1$-$c_4$) to said delay elements ($z^{-1}$) and the weights of said multipliers ($c_1$-$c_4$) according to a predetermined criterion.

5. An adaptive transversal filter circuit as claimed in claim 4, wherein said predetermined criterion is the least mean square error criterion.

6. A method of adaptively filtering a video signal ($X(s)$) to furnish a filtered video signal ($Y(s)$), by means of an adaptive transversal filter circuit (15) including:

a plurality of delay elements ($z^{-1}$) connected in series;
a plurality of multipliers ($c_1$-$c_4$) each connectable to a respective output of a different one of said plurality of delay elements ($z^{-1}$), wherein the number of multipliers ($c_1$-$c_4$) is less than the number of delay elements ($z^{-1}$);
means (40) for connecting selected ones of the multipliers ($c_1$-$c_4$) to the outputs of respective ones of the delay elements ($z^{-1}$); and
summing means ($\Sigma$) for summing the output signals of said multipliers ($c_1$-$c_4$) to develop an output signal; the adaptive transversal filter circuit (15) having a control input for controlling said multipliers ($c_1$-$c_4$) and said connecting means (40), the <u>method being characterized by the steps of</u>:
generating (20) a reference signal ($R(s)$) identical to a predetermined reference signal contained in the video signal;
applying (17) during the occurrence of the predetermined reference signal, the generated reference signal ($R(s)$) to said adaptive transversal filter (15) to furnish a filtered reference signal, and subtracting (11) said filtered reference signal and said reference signal ($R(s)$) from said video signal, to apply (16) a control signal to said control input; and
applying (25; 17) in a cancellation mode, said filtered video signal ($Y(s)$) to said adaptive transversal filter (15) to furnish a filtered output signal, and subtracting (11) said filtered output signal from the video signal thereby cancelling ghost signals from the video signal ($X(s)$) to furnish said filtered video signal ($Y(s)$).

## Patentansprüche

1. Adaptive Filteranordnung (15; 11, 16-25) zum Filtern eines Video-Signals ($X(s)$) zum Liefern eines gefilterten Video-Signals ($Y(s)$), wobei diese Anordnung die nachfolgenden Elemente aufweist:
eine adaptive Transversalfilterschaltung (15) mit:

einer Anzahl reihengeschalteter Verzögerungselemente;
einer Anzahl Multiplizierer ($c_1$-$c_4$), die mit je einem betreffenden Ausgang eines anderen Elementes der genannten Anzahl Verzögerungselemente ($z^{-1}$) verbindbar sind, wobei die Anzahl Multiplizierer ($C_1$-$c_4$) kleiner ist als die Anzahl Verzögerungselemente ($z^{-1}$);
Mittel (40) zum Verbinden selektierter Multiplizierer der Multiplizierer ($c_1$-$c_4$) mit den Ausgängen der betreffenden Verzögerungselemente der Elemente ($z^{-1}$); und
Summierungsmittel ($\Sigma$) zum Summieren der Ausgangssignale der genannten Multiplizierer ($c_1$-$c_4$) zum Entwickeln eines Ausgangssignals; wobei die adaptive Filteranordnung weiterhin die nachfolgenden Elemente aufweist:
Steuermittel (11, 16-25), die mit einem Steuereingang der genannten Multiplizierer ($c_1$-$c_4$) und mit den genannten Verbindungsmitteln (40) gekoppelt sind, <u>dadurch gekennzeichnet</u>, daß die genannten Steuermittel die nachfolgenden Elemente aufweisen:
Subtrahiermittel (11) mit einem Eingang zum Empfangen des genannten Video-Signals ($X(s)$) mit einem Vertikal-Intervalltestsignal, das ein vorbestimmtes Bezugssignal aufweist;
einen Bezugssignalgenerator (20) zum Erzeugen eines Bezugssignals ($R(s)$) entsprechend dem vorbestimmten Bezugssignal;

Mittel (25; 16-18) zum in Antwort auf Vertikal-Intervalltestsignal das Bezugssignal (R(s)) von dem genannten Bezugssignalgenerator (20) dem genannten adaptiven Transversalfilter (15) zuführen zum Liefern eines gefilterten Bezugssignals zu den genannten Subtrahiermitteln (11), zum Zuführen (18) des Bezugssignals (R(s)) zu den genannten Subtrahiermitteln (11) beim Auftritt des Bezugssignals in dem empfangenen Video-Signal und zum Zuführen (16) eines Ausgangssignal der genannten Subtrahiermitteln (11) zu dem genannten Steuereingang; und

Mittel (25; 17) zum Zuführen in einer Löschmode des Ausgangssignals (Y(s)) der genannten Subtrahiermittel (11) zu dem genannten adaptiven Transversalfilter (15) zum Liefern eines gefilterten Subtrahiermittelausgangssignals zu den genannten Subtrahiermitteln (11), wodurch Geisterbildsignale aus dem Video-Signal (X(s)) gelöscht werden zum Liefern des genannten gefilterten Video-Signals (Y(s)).

2. Adaptive Transversalfilterschaltung nach Anspruch 1, wobei die genannten Steuermittel die nachfolgenden Elemente aufweisen:

Mittel zum Vergleichen des Ergebnisses der Subtraktion mit einem Schwellenwert;
Mittel zum Verbinden der genannten Filtermultiplizierer ($c_1$-$c_4$) mit den genannten Filterverzögerungsabgriffen bei Übereinstimmung der Ergebnisse der Subtrahierung, welche den Schwellenwert überschreiten; uns
Mittel zum Einstellen der Multipliziererwerte ($c_1$-$c_4$) zum Minimieren des Ergebnisses der Subtrahierung.

3. Adaptive Transversalfilterschaltung nach Anspruch 2, wobei die genannten Vergleichsmittel dazu vorgesehen sind, einen Schwellenwert zu empfangen, der derart eingestellt ist, daß alle Multiplizierer ($c_1$-$c_4$) verwendet werden.

4. Adaptive Transversalfilterschaltung nach Anspruch 1, wobei die genannten Steuermittel dazu vorgesehen sind, die Verbindungen der genannten Multiplizierer ($c_1$-$c_4$) mit den genannten Verzögerungselementen ($z^{-1}$) und die Gewichtungen der genannten Multiplizierer ($c_1$-$c_4$) entsprechend einem vorbestimmten Kriterium zu steuern.

5. Adaptive Transversalfilterschaltung nach Anspruch 4, wobei das genannte Kriterium das mittlere quadratische Fehlerkriterium ist.

6. Verfahren zur adaptiven Filterung eines Video-Signals (X(s)) zum Liefern eines gefilterten Video-Signals (Y(s)) mittels einer adaptiven Transversalfilterschaltung (15) mit:

einer Anzahl reihengeschalteter Verzögerungselemente ($z^{-1}$);
einer Anzahl Multiplizierer ($c_1$-$c_4$), die mit einem betreffenden Ausgang eines anderen Elementes der genannten Anzahl Verzögerungselemente ($z^{-1}$) verbindbar sind, wobei die Anzahl Multiplizierer ($c_1$-$c_4$) kleiner ist als die Anzahl Verzögerungselemente ($z^{-1}$);
Mitteln (40) zum Verbinden selektierter Multiplizierer der Multiplizierer ($c_1$-$c_4$) mit den Ausgängen der betreffenden Verzögerungselemente der Elemente ($z^{-1}$); und
Summierungsmitteln ($\Sigma$) zum Summieren der Ausgangssignale der genannten Multiplizierer ($c_1$-$c_4$) zum Entwickeln eines Ausgangssignals; wobei das adaptive Transversalfilter (15) einen Steuereingang aufweist zum Steuern der genannten Multiplizierer ($c_1$-$c_4$) und der genannten Verbindungsmittel (40), wobei dieses Verfahren durch die nachfolgenden Verfahrensschritte gekennzeichnet ist:
das Erzeugen (20) eines Bezugssignals (R(s)) entsprechend einem vorbestimmten Bezugssignal in dem Video-Signal;
das Zuführen (17), während des Auftritts des vorbestimmten Bezugssignals, des erzeugten Bezugssignals (R(s)) zu dem genannten adaptiven Transversalfilter (15) zum Liefern eines gefilterten Bezugssignals, und das Subtrahieren (11) des genannten gefilterten Bezugssignals und des genannten Bezugssignals (R(s)) von dem genannten Video-Signal, zum Zuführen (16) eines Steuersignals zu dem genannten Steuereingang; und
das Zuführen (25; 17) in einer Löschmode des genannten gefilterten Video-Signals (Y(s))zu dem genannten adaptiven Transversalfilter (15) zum Liefern eines gefilterten Ausgangssignals und das Subtrahieren (11) des genannten gefilterten Ausgangssignals von dem Video-Signal, wodurch Geisterbildsignale aus dem Video-Signal (X(s)) gelöscht werden zum Liefern des genannten gefilterten Video-Signals (Y(s)).

**Revendications**

1. Montage de filtre adaptatif (15; 11, 16-25) destiné à filtrer un signal vidéo (X(s)) pour fournir un signal vidéo filtré (Y(s)), le montage comprenant :

un circuit de filtre transversal adaptatif (15) comprenant :

une pluralité d'éléments à retard ($z^{-1}$) connectés en série;

une pluralité de multiplicateurs ($c_1$-$c_4$) pouvant être connectés chacun à une sortie respective d'un élément différent de ladite pluralité d'éléments à retard ($z^{-1}$), dans lequel le nombre de multiplicateurs ($c_1$-$c_4$) est inférieur au nombre d'éléments à retard ($z^{-1}$);

un moyen (40) destiné à connecter des multiplicateurs sélectionnés parmi les multiplicateurs ($c_1$-$c_4$) aux sorties d'éléments à retard respectifs parmi les éléments à retard ($z^{-1}$); et

un moyen de sommation ($\Sigma$) destiné à sommer les signaux de sortie des multiplicateurs ($c_1$-$c_4$) pour développer un signal de sortie; le montage de filtre adaptatif comprenant en outre :

des moyens de commande (11, 16-25) couplés à une entrée de commande des multiplicateurs ($c_1$-$c_4$) et du moyen de connexion (40), caractérisé en ce que les moyens de commande comprennent :

un moyen soustracteur (11) présentant une entrée destinée à recevoir le signal vidéo ($X(s)$) contenant un signal d'essai d'intervalle vertical qui comprend un signal de référence prédéterminé;

un générateur de signal de référence (20) destiné à produire un signal de référence ($R(s)$) identique au signal de référence prédéterminé;

des moyens (25; 16-18) réagissant au signal d'essai d'intervalle vertical afin d'appliquer (17) le signal de référence ($R(s)$) provenant du générateur de signal de référence (20) au filtre transversal adaptatif (15) pour fournir un signal de référence filtré au moyen soustracteur (11), afin d'appliquer (18) le signal de référence ($R(s)$) au moyen soustracteur (11) pendant la présence du signal de référence dans le signal vidéo reçu, et afin d'appliquer (16) une sortie du moyen soustracteur (11) à l'entrée de commande; et

des moyens (25; 17) destinés à appliquer, dans un mode d'annulation, la sortie ($Y(s)$) du moyen soustracteur (11) au filtre transversal adaptatif (15) pour fournir un signal de sortie de moyen soustracteur filtré au moyen soustracteur (11), annulant ainsi des signaux d'images fantômes du signal vidéo ($X(s)$) pour fournir le signal vidéo filtré ($Y(s)$).

2. Circuit de filtre transversal adaptatif suivant la revendication 1, dans lequel les moyens de commande comprennent :

des moyens destinés à comparer le résultat de la soustraction avec une valeur de seuil;

des moyens destinés à connecter les multiplicateurs de filtre ($c_1$-$c_4$) aux prises à retard de filtre lors d'une correspondance avec les résultats de la soustraction qui dépassent la valeur de seuil; et

des moyens destinés à ajuster les valeurs de multiplicateurs ($c_1$-$c_4$) pour réduire au minimum le résultat de la soustraction.

3. Circuit de filtre transversal adaptatif suivant la revendication 2, dans lequel les moyens de comparaison sont couplés pour recevoir une valeur de seuil fixée de telle manière que tous les multiplicateurs ($c_1$-$c_4$) soient utilisés.

4. Circuit de filtre transversal adaptatif suivant la revendication 1, dans lequel les moyens de commande sont agencés pour commander les connexions des multiplicateurs ($c_1$-$c_4$) aux éléments à retard ($z^{-1}$) et les poids des multiplicateurs ($c_1$-$c_4$) suivant un critère prédéterminé.

5. Circuit de filtre transversal adaptatif suivant la revendication 4, dans lequel le critère prédéterminé est le critère d'erreur des moindres carrés moyens.

6. Procédé de filtrage adaptatif d'un signal vidéo ($X(s)$) pour fournir un signal vidéo filtré ($Y(s)$), au moyen d'un circuit de filtre transversal adaptatif (15) comprenant :

une pluralité d'éléments à retard ($z^{-1}$) connectés en série;

une pluralité de multiplicateurs ($c_1$-$c_4$) pouvant être connectés chacun à une sortie respective d'un élément différent de ladite pluralité d'éléments à retard ($z^{-1}$), dans lequel le nombre de multiplicateurs ($c_1$-$c_4$) est inférieur au nombre d'éléments à retard ($z^{-1}$);

un moyen (40) destiné à connecter des multiplicateurs sélectionnés parmi les multiplicateurs ($c_1$-$c_4$) aux sorties d'éléments à retard respectifs parmi les éléments à retard ($z^{-1}$); et

un moyen de sommation ($\Sigma$) destiné à sommer les signaux de sortie des multiplicateurs ($c_1$-$c_4$) pour développer un signal de sortie; le circuit de filtre transversal adaptatif (15) comportant une entrée de commande afin de commander les multiplicateurs ($c_1$-$c_4$) et le moyen de connexion (40), le procédé étant caractérisé par les étapes consistant à :

générer (20) un signal de référence (R(s)) identique à un signal de référence prédéterminé contenu dans le signal vidéo;

appliquer (17), pendant l'apparition du signal de référence prédéterminé, le signal de référence produit (R(s)) au filtre transversal adaptatif (15) pour fournir un signal de référence filtré, et soustraire (11) le signal de référence filtré et le signal de référence (R(s)) du signal vidéo, pour appliquer (16) un signal de commande à l'entrée de commande; et

appliquer (25; 17), dans un mode d'annulation, le signal vidéo filtré (Y(s)) au filtre transversal adaptatif (15) pour fournir un signal de sortie filtré, et soustraire (11) le signal de sortie filtré du signal vidéo de manière à annuler les signaux d'images fantômes du signal vidéo (X(s)) pour fournir le signal vidéo filtré (Y(s)).

FIG.1

FIG.2

FIG.3

FIG.4

FIG.6

FIG.5A

FIG.5B

FIG.5C

FIG.7

FIG.8

FIG.9

FIG.10A

FIG.10B

FIG.10C